# EUROPEAN PATENT APPLICATION

(11) **EP 2 133 554 A1**
(43) Date of publication of application: **16.12.2009**
(21) Application number: 08721175.1
(22) Date of filing: 03.03.2008
(51) Int. Cl.: F02P 19/02, F23Q 7/22, H02H 11/00

(54) **GLOW PLUG DRIVE DEVICE**

(30) Priority: 05.03.2007 JP 2007054263
(71) Applicant: Bosch Corporation, Shibuya-ku Tokyo 150-8360 (JP)
(72) Inventor: SUGIMOTO, Hitoshi, Higashi-Matsuyama-shi Saitama 355-8603 (JP); TAKASHIMA, Yoshiaki, Higashi-Matsuyama-shi Saitama 355-8603 (JP); TANAKA, Yutaka, Higashi-Matsuyama-shi Saitama 355-8603 (JP)
(74) Representative: Knapp, Thomas
(86) International application number: PCT/JP2008/053755
(87) International publication number: WO 2008/108330

(57) **Abstract**

In the case where a battery is reversely connected, unnecessary current-carrying to a glow plug is avoided.

Power MOS type field effect transistors 1-1 to 1-n are provided according to a number of glow plugs 5-1 to 5-n to be connected in series between a vehicle battery and the glow plugs 5-1 to 5-n and can be controlled in conduction or non-conduction by a glow-plug control part 51, while a MOS type field effect transistor 2 for protection against reverse connection is provided in series connection between a battery-power joining terminal 3, to which a positive voltage of a vehicle battery is applied, and the ground to cause a reverse current to flow to a fuse 4 through the MOS type field effect transistor 2 at the time of reverse connection of a battery to melt the fuse 4 early whereby current-carrying to the glow plugs 5-1 to 5-n can be avoided.

## Description

### Technical Field

The present invention relates to a glow plug driver used mainly in assisting starting of diesel engines, and more particular, to an improvement in reliability of operation, or the like.

### Background Art

Conventionally, as the driver of this type, it is general to provide a power MOS field effect transistor (referred below to as "power MOS FET") in series between, for example, a battery for a vehicle and a glow plug and to control gate voltage of the power field effect transistor, thereby controlling conduction or non-conduction of the power field effect transistor to enable the energization of the glow plug to be controlled (see, for example, Patent Document 1).

However, the conventional circuit described above involves a problem that when a glow plug is, in particular, of specifications for low voltage, the glow plug generates heat abnormally since the power MOS FET remains conductive due to the structure of the power MOS FET and its operating condition cannot be controlled at the time of reverse connection of the battery.

Patent document 1: Japanese Patent Application Laid-open No. Hei6-129337

### Disclosure of the Invention

### Problems to be Solved by the Invention

The invention has been made in view of the actual situation and has an object to provide a glow plug driver capable of avoiding an unnecessary energization of a glow plug as in the conventional art and ensuring operation high in reliability when a battery is reversely connected.

### Means for Solving the Problems

According to the invention, there is provided a glow plug driver configured to render conductive field effect transistors for driving glow plugs, which are provided according to the number of the glow plugs and connected in series between the glow plugs and a battery to energize the glow plugs,
wherein a field effect transistor or diode for protection against reverse connection is connected in series between the battery and the ground.

### Advantage of the Invention

According to the invention, when a battery is reversely connected, a reverse current is allowed to flow into the battery from the ground through a field effect transistor or diode for protection against reverse connection, to thereby enable melting a fuse in a path. Therefore, the reverse current is cut off quickly at the time of reverse connection and energization of the glow plug is avoided, and in particular, an over-current of a glow plug for low voltage can be surely avoided, thus obtaining an effect that it is possible to ensure operation higher in reliability.

### Brief Description of Drawings

FIG. 1 is a view showing a configuration of a first configurational example of a glow plug driver according to an embodiment of the invention.
FIG. 2 is a view showing a configuration of a second configurational example of a glow plug driver according to an embodiment of the invention.
FIG. 3 is a view showing a configuration of a third configurational example of a glow plug driver according to an embodiment of the invention.

### Explanation of Codes

- 1-1 to 1-n: power MOS field effect transistor
- 2: MOS field effect transistor for protection against reverse connection (first embodiment)
- 3: battery-power joining terminal
- 5: glow-plug control power terminal
- 6: diode for protection against reverse connection (third embodiment)
- 16a, 16b: MOS type field effect transistor for protection against reverse connection (second embodiment)

### Description of Specific Embodiment

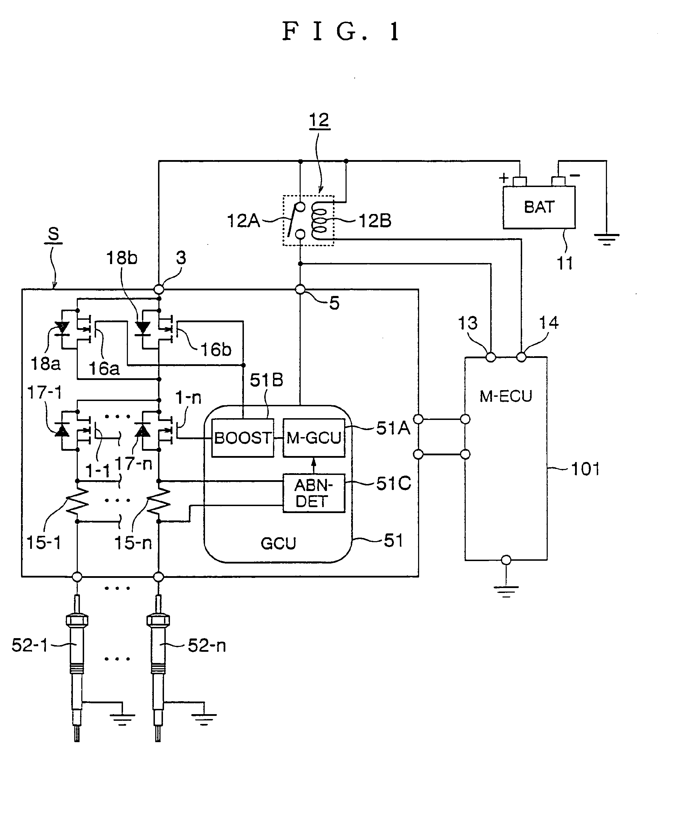

Embodiments of the invention will be described with reference to Figs. 1 to 3.

Members, arrangement, etc. described below do not limit the invention but can be changed variously within a scope of the gist of the invention.

First, a first configurational example of a glow plug driver according to an embodiment of the invention will be described with reference to Fig. 1.

A glow plug driver S according to the embodiment of the invention includes, as main constituents, a glow-plug control part (denoted by "GCU" in Fig. 1) 51, power MOS field effect transistors (referred below to as power MOS FET) 1-1 to 1-n provided according to the number n of glow plugs 52-1 to 52-n, and a MOS field effect transistor for protection against reverse connection (referred below to as MOS FET for protection against reverse connection) 2.

The glow-plug control part 51 is configured to output a gate control voltage for the power MOS FETs 1-1 to 1-n in accordance with a control signal input from a main electronic control unit (denoted by "M-ECU" in Fig. 1) 101, which controls an operation of a whole vehicle, to instruct current-carrying to the glow plugs 52-1 to 52-n.

A voltage obtained by lowering an output voltage of a vehicle battery (not shown) by means of a predetermined voltage transducer circuit is applied as a GCU power supply voltage to the glow-plug control part 51 from an outside through a glow-plug control part power terminal 5.

All the power MOS FETs 1-1 to 1-n are mutually connected at drains (or sources) thereof to be connected to a battery-power joining terminal 3 while being connected at sources (or drains) thereof to predetermined voltage applied terminals (not shown) of the corresponding glow plugs 52-1 to 52-n. The glow plugs 52-1 to 52-n are normally grounded (vehicle body earthed) at terminals thereof on an opposite side to the predetermined voltage applied terminals, to which a voltage is applied.

The MOS FET 2 for protection against reverse connection is connected at a source (or a drain) thereof to the ground while being connected at a drain (or a source) thereof to the mutually connected drains of the power MOS FETs 1-1 to 1-n so as to be connected in parallel to the power MOS FETs 1-1 to 1-n. The gate of the MOS FET 2 for protection against reverse connection is opened.

In Fig. 1, diodes connected in parallel to the power MOS FETs 1-1 to 1-n and the MOS FET 2 for protection against reverse connection, respectively, are each a so-called parasitic diode formed in a transistor.

On the other hand, a fuse 4 for countermeasures against over-current is disposed between a positive electrode terminal (denoted by "(+): Batt" in Fig. 1) of a vehicle battery not shown and the battery-power joining terminal 3 outside the glow plug driver S.

In the configuration described above, a positive voltage of the vehicle battery is applied to the power MOS FETs 1-1 to 1-n in a state where the vehicle battery is normally connected, that is, in a state, where the positive electrode terminal of the vehicle battery not shown is connected to the battery-power joining terminal 3 through the fuse 4.

The glow-plug control part 51 applies a gate voltage to the power MOS FETs 1-1 to 1-n according to a control signal from the main electronic control unit 101 whereby the power MOS FETs are rendered conductive, and the glow plugs 52-1 to 52-n are energized.

On the other hand, when the vehicle battery is erroneously connected, that is, when a negative electrode terminal of the vehicle battery is connected to the battery-power joining terminal 3 through the fuse 4 and a positive electrode terminal of the vehicle battery is connected to the ground, a reverse current flows at a stroke to the vehicle battery through the MOS FET 2 for protection against reverse connection, from the ground (see a broken-line arrow in Fig. 1). Since an electric current in this case becomes an over-current exceeding an electric current specified for the fuse 4, the fuse 4 melts quickly to be opened when the electric current starts to flow. Accordingly, the power MOS FETs 1-1 to 1-n are not rendered conductive, and the energization of the glow plugs 52-1 to 52-n is surely avoided when the vehicle battery is reversely connected.

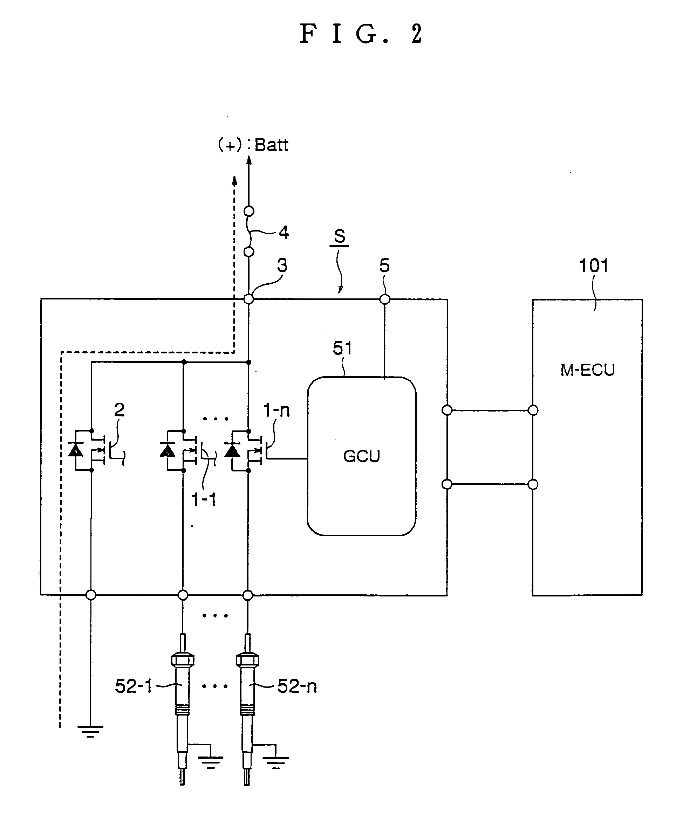

Subsequently, a second configurational example of a glow plug driver according to an embodiment of the invention will be described with reference to Fig. 2. The same constituents as those shown in Fig. 1 are denoted by the same reference numerals as those of the latter, a detailed description thereof will be omitted, and a description will be given below centering around differences.

In the second configurational example, MOS FETs for protection against reverse connection, with drains and sources in a reverse direction to those of power MOS FETs 1-1 to 1-n are provided upstream of the power MOS FETs 1-1 to 1-n, that is, a side, to which a positive voltage of a vehicle battery (denoted by "BAT" in Fig. 2) 11 is applied.

Stated specifically below, in the second configurational example, a main relay 12 is disposed between a main electronic control unit 101 and a positive electrode terminal of the vehicle battery 11.

That is, the main relay 12 in the embodiment of the invention includes a normally open contact 12A and an electromagnetic coil 12B, and both of an end of the normally open contact 12A and an end of the electromagnetic coil 12B are connected to a positive electrode of the vehicle battery 11 while the other end of the normally open contact 12A is connected to a glow-plug control part power terminal 5 and an opening and closing signal terminal 13 of the main electronic control unit 101.

The opening and closing signal terminal 13 is provided for the purposes of determining opening and closing of the normally open contact 12A in the main electronic control unit 101 and controlling operation of the whole driver at need. That is, a voltage of the opening and closing signal terminal 13 is determined in the main electronic control unit 101 whereby opening and closing of the normally open contact 12A is determined.

Also, the other end of the electromagnetic coil 12B is connected to a main relay control terminal 14 provided on the main electronic control unit 101, that is, simultaneously when an ignition key not shown is operated to switch on the ignition the main relay control terminal 14 is connected to the ground through the main electronic control unit 101.

Accordingly, when the ignition key not shown turns on, the electromagnetic coil 12B is excited, so that the normally open contact 12A is closed and a voltage of the vehicle battery 11 is applied to the glow-plug control part 51.

On the other hand, in the second configurational example, current-detection resistors 15-1 to 15-n, respectively, are connected in series between predetermined voltage applying terminals (not shown) of the glow plugs 52-1 to 52-n and sources of the power MOS FETs 1-1 to 1-n. Voltage drop between both ends thereof is detected in the glow-plug control part 51 as described later and detection can be made that an electric current in the glow plugs 52-1 to 52-n becomes abnormal in value.

Two MOS FETs 16a, 16b for protection against reverse connection, which are connected in parallel, are connected in series between drains of the power MOS FETs 1-1 to 1-n and the battery-power joining terminal 3.

That is, the MOS FETs 16a, 16b for protection against reverse connection are mutually connected at sources thereof so as to be connected to the battery-power joining terminal 3 while being connected together at drains thereof and connected to drains of the power MOS FETs 1-1 to 1-n.

Accordingly, the power MOS FETs 1-1 to 1-n and the MOS FETs 16a, 16b for protection against reverse connection are connected in series in a reverse direction between the battery-power joining terminal 3 and predetermined voltage applied terminals of the glow plugs 52-1 to 52-n.

Gate voltages of the power MOS FETs 1-1 to 1-n and the MOS FETs 16a, 16b for protection against reverse connection are both controlled by the glow-plug control part 51 (described below in detail).

In Fig. 2, respective diodes 17-1 to 17-n, 18a, 18b between the sources and drains of the power MOS FETs 1-1 to 1-n and the MOS FETs 16a, 16b for protection against reverse connection are each a so-called parasitic diode formed in a transistor.

In the second configurational example, a configurational example of the glow-plug control part 51 is besides shown, and stated below, the glow-plug control part 51 includes a glow-plug main control part (denoted by "M-GCU" in Fig. 2) 51A, a booster circuit (denoted by "BOOST" in Fig. 2) 51B, and an abnormality detection part (denoted by "ABN-DET" in Fig. 2) 51C.

The glow-plug main control part 51A is configured to put the booster circuit 51B in an operating state in accordance with a control signal, which is input from the main electronic control unit 101 to instruct energization of the glow plugs 52-1 to 52-n, and to stop the operation of the booster circuit 51B to turn off the power MOS FETs 1-1 to 1-n to cut off energization of the glow plugs 52-1 to 52-n when the abnormality detection part 51C outputs a predetermined signal indicating that an electric current flowing in the glow plugs 52-1 to 52-n is abnormal.

As described above, as control is exercised by the glow-plug main control part 51A, the booster circuit 51B is configured to output a gate voltage required for turning the power MOS FETs 1-1 to 1-n and the MOS FETs 16a, 16b for protection against reverse connection on or off.

The abnormality detection part 51C is configured to determine presence or absence of generation of an abnormal current in the glow plugs 52-1 to 52-n on the basis of the magnitude of voltage drop in the current-detection resistors 15-1 to 15-n and to output a predetermined signal to the glow-plug main control part 51A when it is determined that an abnormal current generates.

Subsequently, a description will be given of operation of the above configuration.

First, when the vehicle battery 11 is normally connected, and when power is supplied to the main relay 12 through the main electronic control unit 101, the normally open contact 12A is closed whereby power is also supplied to the glow-plug control part 51, and the glow-plug control part 51 is operable together with the main electronic control unit 101.

In energization of the glow plugs 52-1 to 52-n, the main electronic control unit 101 first outputs a control signal, which should turn on the MOS FETs 16a, 16b for protection against reverse connection, and the booster circuit 51B is put in an operating state by the glow-plug main control part 51A, so that gate voltages allowing the MOS FETs 16a, 16b for protection against reverse connection to turn on are output to gates of the MOS FETs 16a, 16b for protection against reverse connection.

Subsequently, a control signal, which should make the power MOS FETs 1-1 to 1-n on, is output from the main electronic control unit 101 whereby the glow-plug main control part 51A and the booster circuit 51B operate likewise to turn on the power MOS FETs 1-1 to 1-n.

Thereby, an energization current to the glow plugs 52-1 to 52-n flows through the MOS FETs 16a, 16b for protection against reverse connection and the power MOS FETs 1-1 to 1-n from the vehicle battery 11 to bring about a normal energization state.

On the other hand, when the vehicle battery 11 is erroneously connected, that is, when a negative electrode terminal of the vehicle battery 11 is connected to the battery-power joining terminal 3 and a positive electrode terminal of the vehicle battery 11 is connected to the ground, a reverse current is going to flow into the glow plugs 52-1 to 52-n from the ground. In this case, since an ignition key not shown has not been turned on, the power MOS FETs 1-1 to 1-n are turned off, but parasitic diodes 17-1 to 17-n thereof remain in a forward direction relative to a direction, in which a reverse current flows, so that a current path is formed to lead to the glow plugs 52-1 to 52-n, the current-detection resistors 15-1 to 15-n, the parasitic diodes 17-1 to 17-n, and the MOS FETs 16a, 16b for protection against reverse connection from the ground.

Since the MOS FETs 16a, 16b for protection against reverse connection remain off and unlike the case of the parasitic diodes 17-1 to 17-n, the parasitic diodes 18a, 18b are put in a state where cathodes thereof are positioned in a reverse direction to a direction of a reverse current, that is, on a side toward the ground and anodes thereof are positioned on a side toward the battery-power joining terminal 3, however, a reverse current is eventually blocked by the MOS FETs 16a, 16b for protection against reverse connection and the parasitic diodes 18a, 18b thereof, so that energization of the glow plugs 52-1 to 52-n by a reverse current is avoided.

While the two MOS FETs 16a, 16b for protection against reverse connection are connected in parallel in the configurational example shown in Fig. 2, the number of the MOS FETs 16a, 16b for protection against reverse connection should be decided in accordance with the magnitude of a reverse current determined by the size of the vehicle battery 11 and that construction, in which two MOS FETs are connected in parallel, is not necessarily limitative.

Accordingly, in the case where a single MOS FET makes it possible to ensure a fair current capacity, a single MOS FET for protection against reverse connection will do, but in the case where a single MOS FET does not make it possible to ensure a current capacity, that construction, in which plural MOS FETs are connected in parallel in accordance with the magnitude of an electric current allowable for a single MOS FET, is provided.

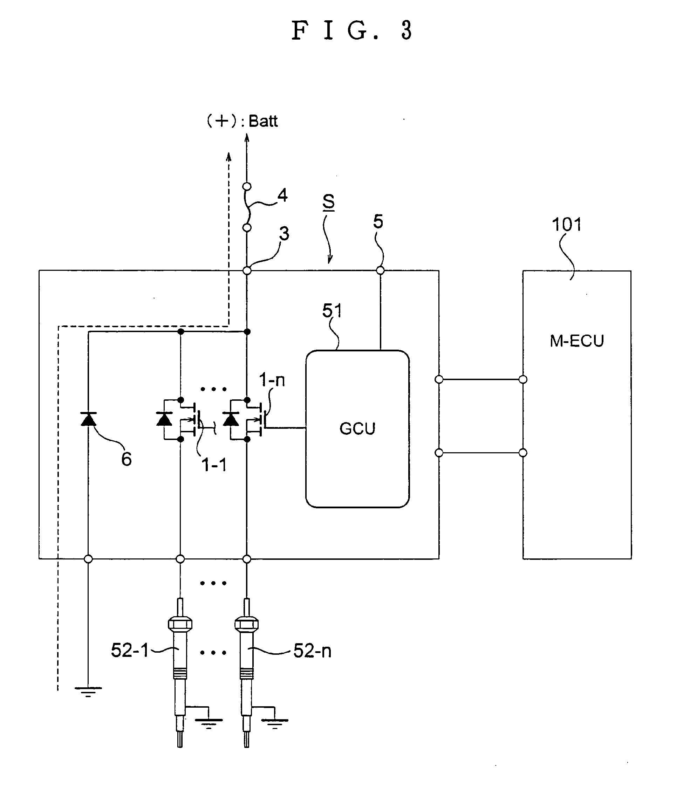

Subsequently, a third configurational example of a glow plug driver according to an embodiment of the invention will be described with reference to Fig. 3. The same constituents as those shown in Fig. 1 are denoted by the same reference numerals as those of the latter, a detailed description thereof will be omitted, and a description will be given below centering around differences.

The third configurational example has a configuration, in which a diode 6 for protection against reverse connection is provided instead of the MOS FET 2 for protection against reverse connection in the first configurational example shown in Fig. 1.

That is, the diode 6 for protection against reverse connection is connected in parallel to power MOS FETs 1-1 to 1-n with an anode thereof connected to the ground and a cathode thereof connected to mutually connected drains of the power MOS FETs 1-1 to 1-n.

Such the construction is the same as the first configurational example shown in Fig. 1 in that in case of erroneous connection of a vehicle battery, a reverse current flows at a stroke to the vehicle battery through the diode 6 for protection against reverse connection from the ground (see a broken-line arrow in Fig. 3) to exceed an electric current specified for a fuse 4, and the fuse 4 is melted quickly, whereby current-carrying to the power MOS FETs 1-1 to 1-n is avoided.

The glow plug driver according to the invention is especially suited to driving of a low-voltage glow plug since a reverse current in a glow plug used mainly in assisting starting of diesel engine can be cut off quickly.

## Claims

1. A glow plug driver configured to render conductive field effect transistors for driving glow plugs, which are provided according to the number of the glow plugs and connected in series between the glow plugs and a battery, energize the glow plugs, wherein a field effect transistor or diode for protection against reverse connection is connected in series between the battery and the ground.

2. The glow plug driver according to claim 1, wherein the field effect transistor for protection against reverse connection has a drain or a source connected together with drains or sources of the field effect transistors for driving glow plugs, which are connected to the battery, and has the source or the drain connected to the ground.

3. The glow plug driver according to claim 1, wherein the field effect transistor for protection against reverse connection is connected in series between the field effect transistors for driving glow plugs and the battery so that a drain or a source thereof is made reverse in direction to drains and sources of the field effect transistors for driving glow plugs.

4. The glow plug driver according to claim 3, wherein the field effect transistors for protection against reverse connection are connected in plural and in parallel in accordance with an energization current to the glow plug.

5. The glow plug driver according to claim 1, wherein the diode for protection against reverse connection has a cathode thereof connected together with the drains or sources of the field effect transistors for driving glow plugs, which are connected to the battery, and has an anode thereof connected to the ground.
